# EUROPEAN PATENT SPECIFICATION

(11) **EP 2 754 164 B1**
(45) Date of publication and mention of the grant of the patent: **13.04.2016**
(21) Application number: 12829437.8
(22) Date of filing: 05.09.2012
(51) Int. Cl.: H01H 47/18, H01H 63/00, H01H 45/14

(54) **TIME DELAY RELAY**
ZEITVERZÖGERUNGSRELAIS
RELAIS À RETARDEMENT

(30) Priority: 06.09.2011 AU 2011903626
(43) Date of publication of application: 16.07.2014
(73) Proprietor: David Stuckey Investments Pty Ltd, Melbourne, VIC 3000 (AU)
(72) Inventor: STUCKEY, David Martin, Hawthorn, Victoria 3122 (AU); GRAHAM, Brent, Pakenham, Victoria 3810 (AU); STRIKE, Michael, Tullamarine, Victoria 3043 (AU); CRIVELLI, Jarrod, Greensborough, Victoria 3088 (AU); NAINGGOLAN, Ingot Marito, Duren Sawit Jakarta Timur 13440 (IN)
(74) Representative: Hirsch & Associés
(86) International application number: PCT/AU2012/001050
(87) International publication number: WO 2013/033765

(56) References cited:
- US-B1- 7 109 833
- US-B1- 7 304 828
- US-B2- 6 708 135
- SQUARE D: 'RM3 Specialty Relays' June 1996, page 18, XP055143773 Retrieved from the Internet: <URL:http://static.schneider-electric.us/do cs/Machine%20Control/Relays%20and%20Timers/ Relays- Insulation%20Control/8430CT9601.pdf> [retrieved on 2012-11-20]

## Description

### FIELD OF THE INVENTION

The invention generally relates to a time delay relay. In particular, the invention relates to a digitally controlled programmable solid-state relay for use in railway applications. More particularly, the invention relates to a programmable solid-state relay, which may be used in retro-fitting an existing electromechanical relay. It will be convenient to hereinafter describe the invention in relation to this particular application. It should be appreciated however that the present invention is not limited to that application only.

### BACKGROUND TO THE INVENTION

Relays are used extensively in the railway industry for the propagation of electrical signals through the railway signalling system and time delay relays are similarly used to delay the propagation of those electrical signals for a predetermined period of time.

Such time delay relays commonly in use by railway systems around the world are generally based upon a resistor-capacitor circuit (RC circuit) time delay. A storage capacitor is charged to a pre-set level and then discharged through a resistor.

In an RC circuit, the value of the time constant (in seconds) is equal to the product of the circuit resistance (in Ohms) and the circuit capacitance (in Farads), *i.e.* τ = R × C. τ is the time required to charge the capacitor, through the resistor, to 63.2% of full charge, or to discharge it to 36.8 % of its initial voltage.

Various delay circuits are known in the art. One approach by Ma, as disclosed in United States Patent No. 7,961,030, uses delay circuits that include a resistor and a capacitor in series. The time delay is related to the resistance of the resistor and the capacitance of the capacitor.

In another approach by Darrow, which is disclosed in United States Patent No. 4,044,272, a fail-safe time delay circuit for providing a time interval is similarly described. The time delay circuit includes a resistance-capacitance charging network, which is connected to a d.c. supply source by a switching device. The potential charge developed on the capacitor powers an inverter to produce a.c. signals having a given frequency. The a.c. signal is then fed to a multi-stage tuned amplifier, having a resonant circuit tuned to the given frequency. The amplified a.c. signals are applied to a voltage doubling network, which normally energizes a load and which maintains the load energized for no longer than the definite time interval after the opening of the switching device.

Hayden, in United States Patent No. 4,276,483, describes a timed switch utilizing a resistive capacitor relaxation oscillator. However, a drawback of this technique is that resistor and capacitor values are nominal only, which prevents an accurate prediction of the resultant time delay and circuits often require fine adjustments to achieve the desired time delay.

It has proved to be problematic in the art to develop practical RC circuits which provide accurate and predictable timing, because the rate of current discharge from the capacitor is exponential rather than linear with time. Time delay relays typically utilize a fixed value capacitor and a variable resistor (potentiometer) to select the desired delay period.

In practice, setting the time delay is usually one of trial and error. The methodology followed is to first set the potentiometer at some nominal value. The relay is then energized and the delay time is measured. The potentiometer is then adjusted, the relay reset and the delay time measured again. This process is repeated, until the desired time delay is achieved or approximated.

A further drawback of the RC timing technique is that the values of these discrete components can be affected by both temperature and aging.

An advantage of the present invention is that it does not rely upon the charge/decay rate of a timing capacitor to control the delay time. Further, the level of complexity which was previously mandatory has been substantially simplified.

Schofield, in United States Patent No. 4,351,014 describes a failsafe solid state relay for alternating current (AC) devices which employs Triodes for alternating current (TRIACs). This approach cannot be applied to direct current (DC) devices as the central component (TRIAC) is limited to AC operation.

Koga et al, in United States Patent No. 4,855,612, also provides a relay which is operable to delay the transition of a plurality of switches using a capacitor as the timing means.

Existing electromechanical relays, such as those used by British Rail, for example, often experience a number of problems, such as, high contact resistance, mechanical wear and tear, susceptibility to environmental conditions, variability of performance based on mechanical and material variation, for example, contact spring tension and the like.

In addition, non-time delay relays suffer from delays caused by their design. The present invention incorporates the use of a transistor or solid state-based switching circuit instead of the mechanical type contact. Further, the present inventors have surprisingly found that by retrofitting the present time delay relay to circuits employing existing electromechanical relays, the function of existing relays can be substantially emulated.

The present invention seeks to overcome, or at least substantially ameliorate, at least some of the disadvantages and shortcomings of the prior art. Document US6708135 (abstract; figure 2f; col 11 line 64 to col 12 line 56) discloses a programmable solid state relay (K201) for comprising: a relay base, a configuration circuit (col.14, 1.25-40); a trigger input; a voltage monitoring circuit (col.6, 1.40-48) monitoring the trigger input; a countdown timer (12-3); a microcontroller; and at least one switching circuits with first and second switching contacts (K201 has contacts), wherein: when the voltage of the trigger input exceeds a trigger input threshold voltage, the countdown timer is loaded with a predetermined time value (delay adjustment circuit 42-3 includes a dip switch for this adjustment), the countdown timer is started and the at least one switching circuits are set to first states; and when the countdown timer has completed its countdown the at least one switching circuits are set to the complements of the first states.

### SUMMARY OF THE INVENTION

According to one form of the invention, there is provided a programmable time delay relay comprising: a relay base; an adapter circuit; a configuration circuit; a voltage monitoring circuit; a countdown timer; a microcontroller; and at least one solid state normally open switching circuits or at least one solid state normally closed switching circuits, wherein: when the voltage of the input exceeds a selectable input threshold voltage the countdown timer is loaded with a predetermined time value, the countdown timer is started and the at least one switches are set to individually predetermined first states; and when the countdown timer has completed its countdown the at least one switches are set to the complements of the first states.

It should be noted that there are no upper or lower limits on the duration of the programmable time delay.

Preferably, the countdown timer is clocked by a clock derived from a stable clock source, wherein the stable clock source is preferably selected from a crystal oscillator or a voltage-controlled oscillator, mains power frequency or a GPS time stamp.

Preferably further, the at least one switching circuits are in the form of both enhancement and depletion mode metal oxide semiconductor field effect transistors ("mosfets") arranged in conjunction with a fuse and rectifier circuit, such that the failure of the at least one switching circuits will result in an open circuit condition.

Advantageously, the relay further comprises means for monitoring the at least one switching circuits. The monitoring means is preferably selected from an analogue to digital converter ("ADC") or a resistor divider network.

In a more preferred embodiment, the relay further comprises visual indicators to show when the countdown timer is in operation, when the countdown timer has completed and the state of each of the at least one outputs.

Preferably, the visual indicators are light emitting diodes. In other preferred forms, the visual indicators are selected from a multi-segmented display or a liquid crystal display ("LCD") display, or a combination of an LCD, a multi-segmented display and an LCD display.

Upon commencement of countdown timer operation, a first colour visual indicator is illuminated. Upon completion of countdown timer operation, the first colour visual indicator is extinguished and a second colour visual indicator is illuminated. These first and second colour visual indicators are preferably separate devices, such as light emitting diodes (LEDs), or alternatively are preferably combined into a single bicolour device, such as a bicolour LED.

Prior to commencement of countdown timer operation and where the relay is equipped with a multi-segmented or LCD display, the display will output the initial value of the countdown timer. Upon commencement of countdown timer operation, the multi-segmented or LCD display will continuously output the current value of the countdown timer. The final value of the countdown timer will continue to be displayed until the threshold voltage is removed.

The threshold voltage is preferably selectable from 5V, 12V, 24V or 50V nominal depending on the application required in a particular jurisdiction. The voltage can be pre-determined prior to being supplied to the customer to suit the particular application required.

In a preferred form of the invention, the source of the selectable input voltage is also selectable. One of the preferred embodiments of the present invention is to provide a "drop-in" replacement for existing electromechanical relays, where the activating voltage is presented on different pins of the plugboard. In order to maintain physical compatibility with these electromechanical relays, it is desirable to be able to select which of these pins will provide the threshold voltage for the present invention.

In order to effect this feature, the signals provided from the plugboard are brought to the configuration module, where the desired threshold voltage signals are selected and routed through to the power supply of the solid state relay.

Electromechanical relays are also generally available in two forms, namely, non-polarized (also known as neutral relays), which only require a voltage potential between two threshold voltage pins; and polarized (also known as biased relays), which require that a first specified pin must be positive with respect to a second specified pin. For example, a neutral relay may only require a voltage to be present across pins R1 and R3, whereas a biased relay may require that R1 must be positive with respect to R3.

Selection of neutral or biased operation is accomplished in the configuration section in a manner similar to the voltage selection, such that the threshold voltage signals are either routed directly to the power supply (neutral) or *via* a diode which prevents voltage of incorrect polarity from energizing the power supply.

The switching circuits of the present invention provide a means of substantially preventing relay component failure from creating a deleterious condition in the overall system application. This deleterious condition is generally manifested where a failure causes a normally open switch to be closed when it should be open. This condition is precluded in the present invention by the unique arrangement of normally open and normally closed solid state switches in conjunction with a fuse and rectifier. Should a normally open solid state switch fail in its normally closed position, the input signal to that switch will be shunted to ground by a normally closed switch creating a short circuit resulting in the fuse opening and isolating the switch output.

A further advantage of the present invention is the capability to provide a switch latching function to the normally open contacts whereby the state of all normally open contacts, once established in their normally closed state, are retained in said normally closed state for an indefinite length of time as long as a voltage is present with respect to ground at the input to the switch. As illustrated Figure 5 at 51, the addition of Zener diodes D9 and D10 between the output of the switch and the gate terminals of Q3, Q4 and Q5 will, once the switch has established its closed position, maintain the switch in the closed position as long as voltage is present at the drain terminal of Q3. Jumper J1 provides the ability to enable this latching function. Diodes D6 and D8 are provided to block any voltage present at the source terminal of mosfet Q4 from being applied to the microcontroller outputs PB0-A and PB1-A.

The programmable solid state relay of the present invention finds particular application in railway signalling and switching applications.

Accordingly, the scope of the present invention also extends to the use and installation of the programmable solid state relay in new railway signalling and switching applications or for use in retrofitting existing railway signalling and switching applications and to a method of removably attaching the relay to a suitably compatible existing railway signalling relay plugboard.

Those skilled in the art will appreciate the strict requirements and regulations governing railway signalling and switching applications in most jurisdictions around the world. The advantages offered by the present solid state relay is that it can form a relay base for ready and removable attachment to such existing plugboards.

It should be noted that any one of the aspects mentioned above may include any of the features of any of the other aspects mentioned above and may include any of the features of any of the embodiments described below as appropriate. For example, the term "countdown timer" is used to describe a counting timer more generally and may also include a count-up timer.

### BRIEF DESCRTPTION OF THE DRAWINGS

The accompanying drawings, which are incorporated in and constitute a part of this specification, illustrate various implementations of the invention and, together with the description, serve to explain the advantages and principles of the invention. In the drawings:
Figure 1 is a block diagram of a relay according to a preferred embodiment of the invention;
Figure 2 is a schematic of the configuration section of the relay;
Figure 3 is a schematic of the power supply section of the relay;
Figure 4 is a schematic of the microcontroller section of the relay;
Figure 5 is a schematic of the switch section of the relay; and
Figure 6 is a flow chart of the software operation of the relay.

### DETAILED DESCRIPTION OF PREFERRED EMBODIMENT

The following detailed description of the invention refers to the accompanying drawings. Wherever possible, the same reference numbers will be used.throughout the drawings and the following description to refer to the same and like parts. Dimensions of certain parts shown in the drawings may have been modified and/or exaggerated for the purposes of clarity or illustration.

The invention is used to delay the propagation of an electrical signal. An input signal is monitored and when it is of an appropriate magnitude and polarity, a plurality of switch signals are asserted for a predetermined time. Various indicia are provided to show the operating state of the switches. The switches and power supply of the system are monitored for short circuit conditions and if detected, the system is set to a known state and fault indicia are illuminated. The system is based around a microcontroller to implement the system logic and provide high accuracy timing derived from a crystal oscillator.

The relay comprises a combination of hardware and logic implemented in the operation of a microcontroller. Whilst the hardware supports the implementation of the logic, it can be described in isolation from it. The hardware provides for the implementation of up to two independent relays (*i.e.* single or dual relays), each based around their own microcontrollers and power supply. As the two relays are identical, only a single relay and the common circuitry will be detailed.

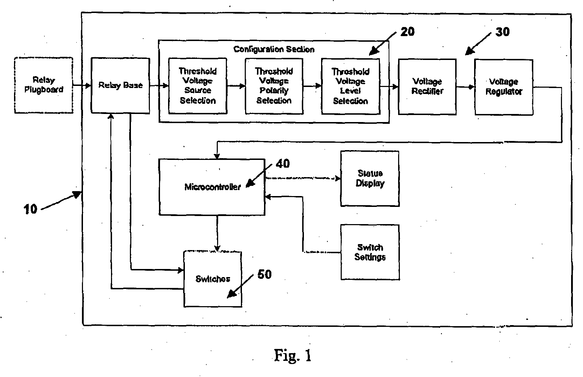

A block diagram of the relay is shown in Figure 1. The relay 10 comprises a configuration section 20, power supply 30, microcontroller section 40 and switch section 50.

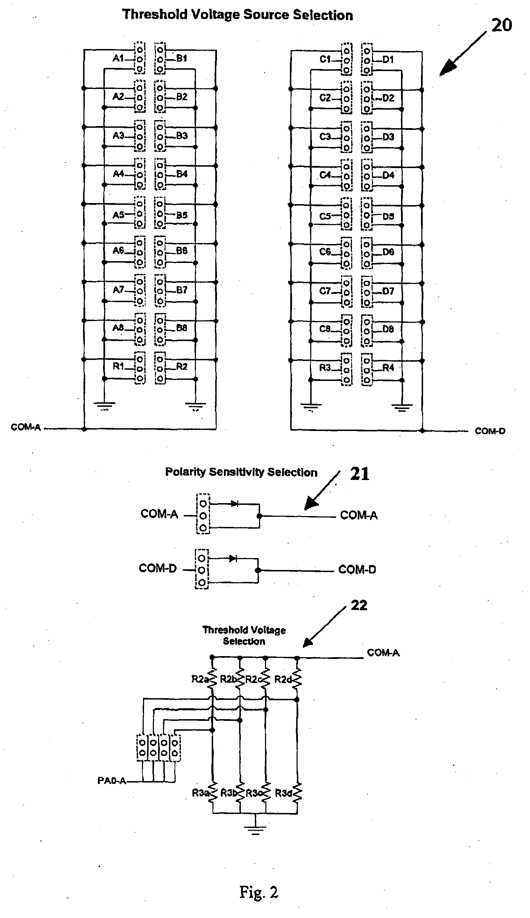

Figure 2 illustrates the means by which the various desired parameters of the threshold voltage may be selected. These various parameters include voltage source, voltage polarity and voltage level.

The threshold voltage source portion of the configuration section at 20 is shown in Figure 2 and provides the ability to select the individual pins present on a relay plugboard for providing the threshold voltage for the relay, as well as selecting the sensitivity of the relay to the polarity of the threshold voltage.

The polarity sensitivity portion of the configuration section is illustrated at 21 in Figure 2 and provides for the ability to restrict operation of the relay to the polarity as determined by placement of the jumpers.

The threshold voltage level portion of the configuration circuit is illustrated at 22 in Figure 2 and provides for the selection of the threshold voltage at which the relay will operate as determined by the placement of jumpers which select the resistor divider network corresponding to the desired threshold voltage.

In the preferred embodiment illustrated in Figure 2, the threshold voltage source selection circuit for COM-A is shown generally at 21 and is preferably derived from any of the contacts shown through the installation of the appropriate jumpers. Voltage selection for COM-D is similar.

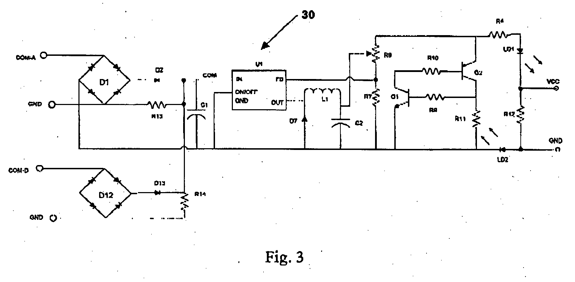

The power supply section 30 is shown in Figure 3 and provides reverse polarity and overvoltagc protection to the relay. The input to the relay COM-A is fed through bridge rectifier D1 to the voltage regulator input COM. This protects the circuitry from reverse polarity and diodes D2 and D13 allow the COM-D input for an independent second relay to also be coupled to the power supply 30, allowing the common power supply to operate in the presence of an input signal to just either relay or to both relays.

The voltage regulator input COM has any AC component filtered out by capacitor C1 before passing to the actual voltage regulator device U1, a step-down switching regulator. The switch voltage of U1 is set by resistors R6 and R7 to 5V and further filtered by inductor L1, capacitor C2 and diode D7 to provide a filtered, regulated Vcc supply voltage for the microcontroller µC-A.

When Vcc voltage is present at the collector of transistor Q2, transistor Q1 will turn on and conduct through R8 and R9. This will turn on transistor Q2 providing short circuit protection.

In the absence of a short circuit, LED LD2 is illuminated by virtue of current flowing between Vcc and ground *via* LD2 and R12. LED LD1 is off during this period, since Vcc appears at both its anode and cathode.

In the event of a short circuit, Vcc will be forced to ground which will pull the base of transistor Q1 to ground turning Q1 off. When transistor Q1 is off, there will be no voltage at the base of transistor Q2 and it will turn off illuminating LD1 and extinguish LD2 to indicate the presence of a short circuit fault.

LD1 thus provides an indication of the power supply being functional, but having a short present on Vcc. LD2 indicates that the power supply is functional and all is well.

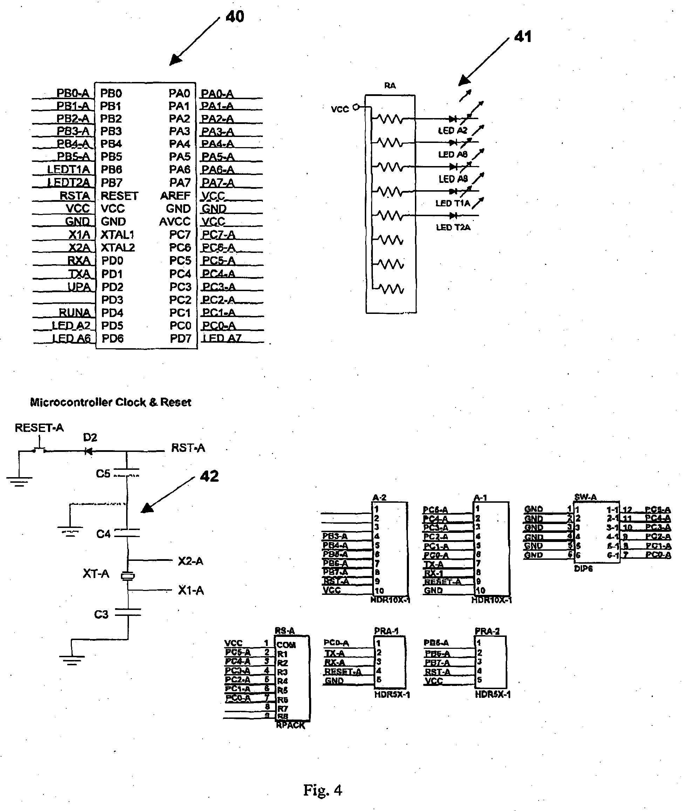

The microcontroller section 40 is shown in Figure 4 and is based around an ATMEGA8535 8-bit microcontroller µC-A. Microcontroller µC-D, where provided is similar. The microcontroller includes four 8-bit i/o ports, a programmable countdown timer and Ports A-D, which can be configured for various functions.

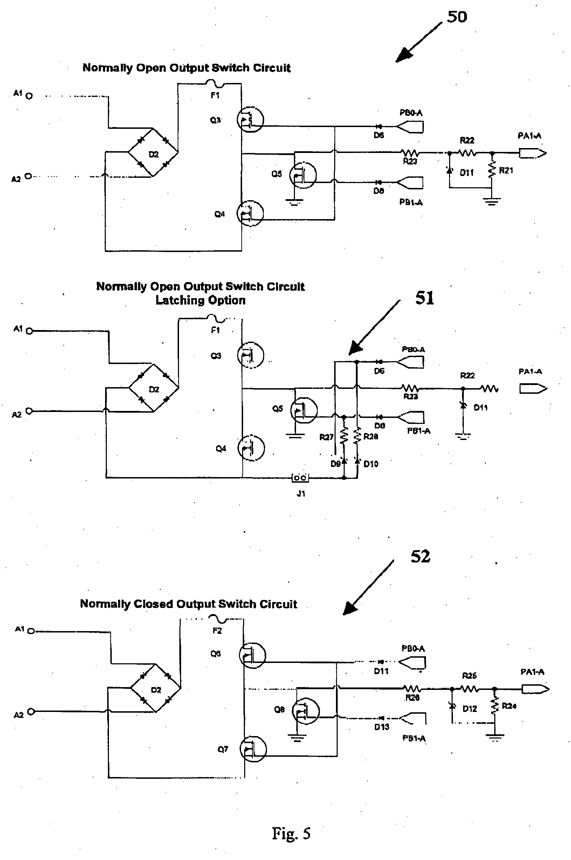

Port A is configured as an input port and is used as an analog to digital converter to measure the input voltage monitor using PA0-A and switch monitoring signals via PA1-A, through PA7-A from the switch section 50 shown in Figure 5 which illustrates a typical arrangement of the switch monitoring circuits.

Port B is configured as an output port to control the switches A2, A6 and A8 of the switch section 50 shown in Figure 5 *via* signals PB0-A through PB5-A respectively which illustrates a typical arrangement of the switch control circuits

Port B is also used to drive two status LEDs shown at 41 as LED T1A (PB6-A) and LED T2A (PB7-A).

Port C is configured as an input port and is used to read configuration settings from the DIP switches SW-A. The switches are used to select a time delay value for the relay.

Port D is used to provide an RS232 serial interface to an external device via PD0 and PD1 which carry received data (PD0) and transmitted data (PD1) respectively and allow new software to be uploaded to the microcontroller. Port D also provides an interface to an external momentary pushbutton device to provide logic low pulses to modify the timing parameters (PD2 and PD4).

Port D is also used to drive three status LEDs shown at 41 as LED A2 (PD5), LED A6 (PD6) and LED A8 (PD7).

The clock for microcontroller µC-A is generated by a crystal XT-A as shown at 42 to produce a highly stable timing base for all timing operations. In one form, the microcontroller preferably includes a programmable countdown timer, which is set according to the time delay value read from Port C.

The present invention preferably further includes a number of solid state switches which arc preferably in the form of normally open switches or normally closed switches. A single normally open switch 50 is shown in Figure 5 and provides a normally open switch between contacts A1 and A2. Diode rectifier circuit D2 is utilized to ensure that when a voltage is applied across A1 and A2 that the drain connections of the mosfets are always positive with respect to the source connections.

The signals in Figure 5 designated as PB0-A, PB1-A and PA1-A represent typical configurations.

Mosfets Q3 and Q4 arc enhancement mode mosfets and, in the absence of any gate voltage, will be in their high resistance (off) state. Mosfet Q5 is a depletion mode mosfet and, in the absence of any gate voltage, will be in its low resistance (on) state.

Upon receiving a signal from the microcontroller at PB1-A0, mosfet Q5 will change to its high resistance (off) state and upon receiving a signal from the microcontroller at PB0-A, mosfets Q3and Q4 will change to their low resistance (on) state, effectively connecting terminal A1 to terminal A2.

The microcontroller is programmed to control the state of mosfets Q3,Q4 and Q5. The microcontroller first turns on mosfet Q5, isolating the drain connection of mosfet Q5 from ground. After a short delay, which substantially emulates the reaction time of an electromechanical relay, the microcontroller turns on mosfets Q3 and Q4 closing the switch circuit allowing current to flow between contacts A1 and A2.

One preferred aspect of the present invention is its ability to detect component failures and substantially prevent unsafe switch states from occurring. The health of mosfet Q5 is first checked by the microcontroller at PA1-A before any activation signals are generated at PB0-A and PB1-A. If mosfet Q5 is in its desired state, then the voltage at PA1-A will be logic low, as it is effectively shorted to ground. The microcontroller will then apply a short pulse to the gate of mosfet Q5 *via* PB1-A to turn off mosfet Q5 and the state of PA1-A is read again by the microcontroller. Internal pull-up resistors on PA1-A in the microcontroller will ensure that the voltage at PA1-A will be logic high provided mosfet Q5 can be turned off. If the logic high signal is not seen by the microcontroller at this point, the microcontroller will hold the relay in an error state and maintain the default state for all switches.

If mosfet Q3 fails in the open state, then the switch will remain open. The microcontroller will detect the failure of PA1-A to go to a logic high state and will hold the relay in an error state as described above.

If mosfet Q3 fails in a closed state, then a low resistance path is present to ground *via* mosfet Q5 and fuse F1 will open effectively forcing the switch to an open state.

If mosfet Q4 fails in the open state, then the switch will remain open.

Similarly, a single normally closed switch 52 is shown in Figure 5 and provides a normally closed switch between contacts A1 and A2. Diode rectifier circuit D2 is utilized to ensure that when a voltage is applied across A1 and A2 that the drain connections of the mosfets arc always positive with respect to the source connections.

Mosfets Q6 and Q7 are depletion mode mosfets and, in the absence of any gate voltage, will be in their low resistance (on) state. Mosfet Q8 is an enhancement mode mosfet and, in the absence of any gate voltage, will be in its high resistance (off) state.

Upon receiving a signal from the microcontroller at PB1-A, mosfet Q8 will change to its low resistance (on) state and upon receiving a signal from the microcontroller at PB0-A, mosfets Q6 and Q7 will change to their high resistance (off) state, effectively disconnecting terminal A1 from terminal A2.

The microcontroller is programmed to control the state of mosfets Q6, Q7 and Q8. The microcontroller first turns on mosfets Q6 and Q7, isolating contacts A1 and A2. After a short delay, which emulates the reaction time of an electromechanical relay, the microcontroller turns on mosfet Q8.

One further preferred aspect of the present invention is its ability to detect component failures and substantially prevent unsafe switch states from occurring. The health of mosfet Q8 is first checked by the microcontroller at PA1-A before any activation signals are generated at PB0-A and PB1-A. If mosfet Q1 is in its desired state, then the voltage at PA1-A will be logic high.

The microcontroller will then turn on mosfets Q6 and Q7, isolating contacts A1 and A2 and will then turn on mosfet Q8.

If mosfet Q6 or Q7 fail in their off state, then contact A1 will be isolated from contact A2.

If mosfet Q6 fails in its on state then, when mosfet Q8 is turned on, a low resistance path is present to ground via mosfet Q8 and fuse F2 will open effectively forcing the switch to an open state

The microcontroller checks the health of mosfet Q8 by checking that PA1 -A is at a logic high level, while mosfets Q1 and Q2 are in their low resistance state by applying a short pulse *via* PB1-A while mosfets Q7 and Q8 are in their high resistance states.

The normally open switch circuit 51 may have several components added to form a latching option as shown in circuit 52. Zener diodes D9 and D10 will, once the switch has established its closed state, maintain the switch in a closed state as long as voltage is present at the source terminal of mosfet Q4. The option is selectable by jumper J1. Diodes D6 and D8 serve to isolate the microcontroller.

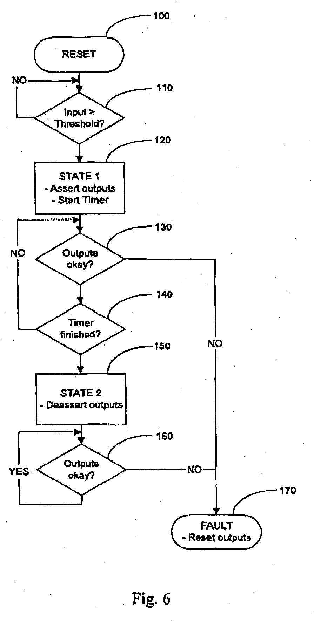

The operation of the programmable relay is controlled by software running on the microcontroller µC-A and can be appreciated with the aid of the flow chart in Figure 6, which shows the operation of the relay.

At step 100, the relay enters the RESET state, either as a result of powering up or assertion of the reset switch RSTA. In RESET, all of the switches and LEDs are turned off.

Following RESET at step 110, the input voltage is monitored *via* signal PA0-A, and when above a predetermined threshold, the relay moves to STATE 1.

In STATE 1 at step 120, the switches A2, A6 and A8 are asserted to their predetermined STATE 1 condition, which may be either on or off on a per switch basis. The microcontroller's countdown timer is loaded with a predetermined time selected according to the value set by the DIP switches SW-A read via Port C. The countdown timer is then started.

At step 130, the switches are checked and if not as expected, the FAULT state at step 170 is entered.

At step 140 the timer is checked, and if completed STATE 2 is entered, otherwise step 130 is repeated.

STATE 2 at step 150 is entered following completion of the countdown timer. In STATE 2, all of the switches are de-asserted, that is, they are set to the complement of their STATE 1 condition.

The switches are then monitored at step 160 and if not as expected, the FAULT state at step 170 is entered.

The FAULT state at step 170 is entered whenever the output monitoring signals indicate that a switch is not operating correctly, *i.e.* a short circuit condition has been detected. In the FAULT state, all of the switches are turned off.

The software controls a number of LEDs to provide visual status indicators. LEDs A2, A6 and A8 indicate whether the corresponding switches are on or off. LED T1A indicates that the relay is in STATE 1, i.e. the timer is counting down. LED T2A indicates that the relay is in STATE 2, i.e. that the timer has finished.

The skilled reader will now appreciate the benefits of the present invention in providing a relay with precision timing capabilities, multiple switches with fault monitoring capabilities and multiple visual indicators.

## Claims

1. A programmable solid state relay comprising: a relay base, an adaptor circuit; a configuration circuit; a trigger input; a voltage monitoring circuit monitoring the trigger input; a countdown timer; a microcontroller; and at least one switching circuits with first and second switching contacts, wherein: when the voltage of the trigger input exceeds a selectable trigger input threshold voltage, the countdown timer is loaded with a predetermined time value, the countdown timer is started and the at least one switching circuits are set to individually predetermined first states; and when the countdown timer has completed its countdown the at least one switching circuits are set to the complements of the first states.

2. A programmable solid state relay according to claim 1, wherein the at least one switching circuits are selected from a normally open or a normally closed switching circuit.

3. A programmable solid state relay according to claim 1 or claim 2, wherein a specific set of operating parameters for the relay are selectable by the configuration circuit including:
i) a source for the trigger input;
ii) a value for the trigger input threshold voltage;
iii) a polarity of the trigger input threshold voltage; and
iv) the state of the at least one switching circuits,
whereby an existing state upon removal of the trigger input voltage is retained.

4. A programmable solid state relay according to claim 2, wherein when the at least one switching circuits comprises a normally open switching circuit, the normally open switching circuit comprises a fuse, a rectifier, a first normally open switch, a second normally open switch and a normally closed switch whereby, should the normally closed switch be closed while the first normally open switch is closed, excessive current will flow through the fuse causing it to open, thus effectively isolating the first and second switching contacts of the normally open switching circuit.

5. A programmable solid state relay according to claim 2, wherein when the at least one switching circuits comprises a normally closed switching circuit, the circuit comprises a fuse, a rectifier, a first normally closed switch, a second normally closed switch and a normally open switch whereby, should the normally open switch be closed while the first normally open switch is closed, excessive current will flow through the fuse causing it to open, thus effectively isolating the first and second switching contacts of the normally closed switching circuit.

6. A programmable solid state relay according to claim 4, wherein the normally open switches comprise enhancement mode mosfets and the normally closed switch comprises a depletion mode mosfet wherein simultaneous closure of both said normally open and normally closed switches will result in excessive current through a fuse causing it to result in an open circuit.

7. A programmable solid state relay according to claim 4, wherein the normally open switches comprise depletion mode MOSFETs and the normally closed switch comprises an enhancement mode MOSFET wherein simultaneous closure of both said normally open and normally closed switches will result in excessive current through a fuse causing it to result in an open circuit.

8. A programmable solid state relay according to any one of claims 1 to 7, wherein the countdown timer is clocked by a clock derived from a stable clock source.

9. A programmable solid state relay according to any one of claims 1 to 8, further comprising means for monitoring the at least one switching circuits.

10. A programmable solid state relay according to claim 9, wherein the monitoring means is selected from an analogue to digital converter ("ADC") or a resistor divider network.

11. A programmable solid state relay according to any one of claims 1 to 10, further comprising at least one visual indicators to show when the countdown timer is in operation and when the countdown timer has completed.

12. A programmable solid state relay according to claim 11, wherein said visual indicators are selected from light emitting diodes, a multi-segmented display or a liquid crystal display or combinations thereof.

13. A programmable solid state relay according to any one of claims 1 to 12, wherein the threshold voltage is selected from 5V, 12V, 24V or 50V nominal.

14. A programmable solid state relay according to any one of claims 1 to 13, further comprising a switch latching function to the normally open switches, whereby the state of all normally open switches, once established in their normally closed state, are retained in said normally closed state for an indefinite length of time as long as a voltage is present with respect to ground at the first or second switching contacts to the switch.

15. The use of the programmable solid state relay according to any one of claims 1 to 14 in a railway signalling and switching application.

16. A method of installing a programmable solid state relay according to any one of claims 1 to 14 in a railway signalling and switching application, comprising the steps of:
(i) selecting at least one suitable connections on the relay base to supply the trigger input;
(ii) selecting the value of the trigger input threshold voltage;
(iii) selecting the polarity of the trigger input threshold voltage;
(iv) selecting the ability of the at least one switching circuits to retain its existing state upon removal of the trigger input; and
(v) removably attaching the relay base from step (i) to a plugboard.

17. A method according to claim 16, wherein a plurality of programmable solid state relays are installed in step (v).

18. A method according to claim 16 or claim 17, wherein the plugboard is a signalling relay plugboard.

## Patentansprüche

1. Programmierbares Halbleiterrelais, das Folgendes umfasst: eine Relaisbasis, eine Adapterschaltung; eine Konfigurationsschaltung; einen Trigger-Eingang; eine Spannungsüberwachungsschaltung, die den Trigger-Eingang überwacht; einen Countdown-Zähler; einen Mikrocontroller und mindestens einen Schaltstromkreis mit ersten und zweiten Schaltkontakten, wobei: wenn die Spannung des Trigger-Eingangs eine auswählbare Trigger-Eingangsgrenzspannung überschreitet, der Countdown-Zähler mit einem vorherbestimmten Zeitwert geladen wird, der Countdown-Zähler gestartet wird und der mindestens eine Schaltstromkreis auf einen einzeln vorherbestimmten ersten Zustand eingestellt wird; und wenn der Countdown-Zähler seinen Countdown abgeschlossen hat, der mindestens eine Schaltstromkreis auf das Komplement des ersten Zustands eingestellt wird.

2. Programmierbares Halbleiterrelais nach Anspruch 1, wobei der mindestens eine Schaltstromkreis aus einem normalerweise offenen oder einem normalerweise geschlossenen Schaltstromkreis ausgewählt ist.

3. Programmierbares Halbleiterrelais nach Anspruch 1 oder 2, wobei ein spezifischer Satz von Betriebsparametern für das Relais durch die Konfigurationsschaltung auswählbar ist, der Folgendes beinhaltet:
i) eine Quelle für den Trigger-Eingang;
ii) einen Wert für die Trigger-Eingangsgrenzspannung;
iii) eine Polarität der Trigger-Eingangsgrenzspannung und
iv) den Zustand des mindestens einen Schaltstromkreises,
wobei ein existierender Zustand bei Abziehen der Trigger-Eingangsspannung beibehalten wird.

4. Programmierbares Halbleiterrelais nach Anspruch 2, wobei, wenn der mindestens eine Schaltstromkreis einen normalerweise offenen Schaltstromkreis umfasst, der normalerweise offene Schaltstromkreis eine Sicherung, einen Gleichrichter, einen ersten normalerweise offenen Schalter, einen zweiten normalerweise offenen Schalter und einen normalerweise geschlossenen Schalter umfasst, wodurch, wenn der normalerweise geschlossene Schalter geschlossen sein sollte, während der erste normalerweise offene Schalter geschlossen ist, übermäßiger Strom durch die Sicherung fließen wird, was bewirkt, dass diese sich öffnet, wodurch die ersten und die zweiten Schaltkontakte des normalerweise offenen Schaltstromkreises effektiv isoliert werden.

5. Programmierbares Halbleiterrelais nach Anspruch 2, wobei, wenn der mindestens eine Schaltstromkreis einen normalerweise geschlossenen Schaltstromkreis umfasst, der Schaltstromkreis eine Sicherung, einen Gleichrichter, einen ersten normalerweise geschlossenen Schalter, einen zweiten normalerweise geschlossenen Schalter und einen normalerweise offenen Schalter umfasst, wodurch, wenn der normalerweise offene Schalter geschlossen sein sollte, während der erste normalerweise offene Schalter geschlossen ist, übermäßiger Strom durch die Sicherung fließen wird, was bewirkt, dass diese sich öffnet, wodurch die ersten und die zweiten Schaltkontakte des normalerweise geschlossenen Schaltstromkreises effektiv isoliert werden.

6. Programmierbares Halbleiterrelais nach Anspruch 4, wobei die normalerweise offenen Schalter Anreicherungstyp-MOSFET umfassen und der normalerweise geschlossenen Schalter einen Verarmungstyp-MOSFET umfassen, wobei ein gleichzeitiges Schließen sowohl der normalerweise offenen Schalter als auch der normalerweise geschlossenen Schalter zu einem übermäßigen Strom durch eine Sicherung führen wird, was bewirkt, dass diese zu einem offenen Stromkreis führt.

7. Programmierbares Halbleiterrelais nach Anspruch 4, wobei die normalerweise offenen Schalter Verarmungstyp-MOSFET umfassen und der normalerweise geschlossenen Schalter einen Anreicherungstyp-MOSFET umfassen, wobei ein gleichzeitiges Schließen sowohl der normalerweise offenen Schalter als auch der normalerweise geschlossenen Schalter zu einem übermäßigen Strom durch eine Sicherung führen wird, was bewirkt, dass diese zu einem offenen Stromkreis führt.

8. Programmierbares Halbleiterrelais nach einem der Ansprüche 1 bis 7, wobei der Countdown-Zähler von einem Taktgeber getaktet wird, der von einer stabilen Taktgeberquelle abgeleitet ist.

9. Programmierbares Halbleiterrelais nach einem der Ansprüche 1 bis 8, das weiterhin ein Mittel zum Überwachen des mindestens einen Schaltstromkreises umfasst.

10. Programmierbares Halbleiterrelais nach Anspruch 9, wobei das Überwachungsmittel aus einem Analog-DigitalUmsetzer ("ADU") oder einem Widerstandsteilernetzwerk ausgewählt ist.

11. Programmierbares Halbleiterrelais nach einem der Ansprüche 1 bis 10, das weiterhin mindestens einen optischen Indikator umfasst, um anzuzeigen, wenn der Countdown-Zähler im Betrieb ist und wenn der Countdown-Zähler abgeschlossen ist.

12. Programmierbares Halbleiterrelais nach Anspruch 11, wobei die optischen Indikatoren aus Leuchtdioden, einer Multisegment-Anzeige oder einer Flüssigkristallanzeige oder Kombinationen davon ausgewählt sind.

13. Programmierbares Halbleiterrelais nach einem der Ansprüche 1 bis 12, wobei die Grenzspannung aus 5 V, 12 V, 24 V oder 50 V Nennspannung ausgewählt ist.

14. Programmierbares Halbleiterrelais nach einem der Ansprüche 1 bis 13, das weiterhin eine Schalterrastfunktion zu den normalerweise offenen Schaltern umfasst, wodurch der Zustand aller normalerweise offenen Schalter, sobald diese in ihrem normalerweise geschlossenen Zustand festgelegt sind, in dem normalerweise geschlossenen Zustand für eine unbestimmte Zeitdauer beibehalten wird, solange Spannung in Bezug auf Masse an den ersten und den zweiten Schaltkontakten zu dem Schalter vorhanden ist.

15. Verwendung des programmierbaren Halbleiterrelais nach einem der Ansprüche 1 bis 14 in einer Eisenbahnsignal- und -schaltanwendung.

16. Verfahren zum Installieren eines programmierbaren Halbleiterrelais nach einem der Ansprüche 1 bis 14 in einer Eisenbahnsignal- und -schaltanwendung, wobei das Verfahren die folgenden Schritte umfasst:
(i) Auswählen mindestens einer geeigneten Verbindung auf der Relaisbasis, um den Trigger-Eingang zu liefern;
(ii) Auswählen des Werts der Trigger-Eingangsgrenzspannung;
(iii) Auswählen der Polarität der Trigger-Eingangsgrenzspannung;
(iv) Auswählen der Fähigkeit des mindestens einen Schaltstromkreises, um seinen existierenden Zustand bei Abziehen des Trigger-Eingangs zu bewahren; und
(v) abnehmbares Anbringen der Relaisbasis aus Schritt
(i) an einem Schaltbrett.

17. Verfahren nach Anspruch 16, wobei mehrere programmierbare Halbleiterrelais in Schritt (v) installiert werden.

18. Verfahren nach Anspruch 16 oder 17, wobei das Schaltbrett ein Signalrelais-Schaltbrett ist.

## Revendications

1. Relais programmable à semi-conducteurs comprenant : une base de relais, un circuit adaptateur; un circuit de configuration; une entrée de déclenchement; un circuit de surveillance de tension surveillant l'entrée de déclenchement; un compteur à rebours; un microcontrôleur; et au moins un circuit de commutation avec des premier et deuxième contacts de commutation, dans lequel: quand la tension de l'entrée de déclenchement dépasse un seuil de tension d'entrée de déclenchement sélectionnable, le compteur à rebours reçoit une valeur de temps prédéterminée, le compteur à rebours est démarré et l'au moins un circuit de commutation est réglé à des premiers états individuellement prédéterminés; et, quand le compteur à rebours est arrivé au bout de son cycle de comptage à rebours, l'au moins un circuit de commutation est réglé aux compléments des premiers états.

2. Relais programmable à semi-conducteurs selon la revendication 1, dans lequel l'au moins un circuit de commutation est choisi parmi un circuit de commutation normalement ouvert ou un circuit de commutation normalement fermé.

3. Relais programmable à semi-conducteurs selon la revendication 1 ou 2, dans lequel un ensemble spécifique de paramètres de fonctionnement pour le relais sont sélectionnables par le circuit de configuration, comprenant :
i) une source pour l'entrée de déclenchement ;
ii) une valeur de seuil de tension d'entrée de déclenchement ;
iii) une polarité du seuil de tension d'entrée de déclenchement ; et
iv) l'état de l'au moins un circuit de commutation,
de sorte qu'un état existant lors de la disparition de la tension d'entrée de déclenchement soit conservé.

4. Relais programmable à semi-conducteurs selon la revendication 2, dans lequel, lorsque l'au moins un circuit de commutation comprend un circuit de commutation normalement ouvert, le circuit de commutation normalement ouvert comprend un fusible, un redresseur, un premier commutateur normalement ouvert, un deuxième commutateur normalement ouvert et un commutateur normalement fermé de sorte que dans le cas où le commutateur normalement fermé est fermé tandis que le premier commutateur normalement ouvert est fermé, un courant excessif circulera à travers le fusible provoquant son ouverture, isolant ainsi efficacement les premier et second contacts de commutation du circuit de commutation normalement ouvert.

5. Relais programmable à semi-conducteurs selon la revendication 2, dans lequel, lorsque l'au moins un circuit de commutation comprend un circuit de commutation normalement fermé, le circuit comprend un fusible, un redresseur, un premier commutateur normalement fermé, un second commutateur normalement fermé et un commutateur normalement ouvert de sorte que dans le cas où le commutateur normalement ouvert est fermé tandis que le premier commutateur normalement ouvert est fermé, un courant excessif circulera à travers le fusible provoquant son ouverture, isolant ainsi efficacement les premier et second contacts de commutation du circuit de commutation normalement fermé.

6. Relais programmable à semi-conducteurs selon la revendication 4, dans lequel les commutateurs normalement ouverts comprennent des MOSFETs à enrichissement et le commutateur normalement fermé comprend un MOSFET à appauvrissement, dans lequel la fermeture simultanée desdits commutateurs normalement ouverts ainsi que les commutateurs normalement fermés se traduira par un courant excessif à travers un fusible dont le résultat est un circuit ouvert.

7. Relais programmable à semi-conducteurs selon la revendication 4, dans lequel les commutateurs normalement ouverts comprennent des MOSFETs à appauvrissement et le commutateur normalement fermé comprend un MOSFET à enrichissement, dans lequel la fermeture simultanée desdits commutateurs normalement ouverts ainsi que les commutateurs normalement fermés se traduira par un courant excessif à travers un fusible dont le résultat est un circuit ouvert.

8. Relais programmable à semi-conducteurs selon l'une quelconque des revendications 1 à 7, dans lequel le compteur à rebours est cadencé par une horloge dérivée d'une source d'horloge stable.

9. Relais programmable à semi-conducteurs selon l'une quelconque des revendications 1 à 8, comprenant en outre des moyens de surveillance des au moins un circuit de commutation.

10. Relais programmable à semi-conducteurs selon la revendication 9, dans lequel les moyens de surveillance sont choisis parmi un convertisseur analogique-numérique («CAN») ou un réseau diviseur à résistances.

11. Relais programmable à semi-conducteurs selon l'une quelconque des revendications 1 à 10, comprenant en outre au moins un indicateur visuel pour indiquer que le compteur à rebours est en marche et lorsque le compteur à rebours est terminé.

12. Relais programmable à semi-conducteurs selon la revendication 11, dans lequel lesdits indicateurs visuels sont choisis parmi les diodes électroluminescentes, un écran multi-segmenté ou un affichage à cristaux liquides ou des combinaisons de ceux-ci.

13. Relais programmable à semi-conducteurs selon l'une quelconque des revendications 1 à 12, dans lequel le seuil de tension de est choisi parmi des tensions nominales de 5V, 12V, 24V ou de 50V.

14. Relais programmable à semi-conducteurs selon l'une quelconque des revendications 1 à 13, comprenant en outre une fonction de verrouillage de commutateur pour les commutateurs normalement ouverts, de sorte que l'état de tous les commutateurs normalement ouverts, une fois établis dans leur état normalement fermé, sont maintenus audit état normalement fermé pour une durée indéterminée, à condition qu'une tension soit présente par rapport à la terre, au premier ou au second contact de commutation du commutateur.

15. L'utilisation du relais programmable à semi-conducteurs selon l'une quelconque des revendications 1 à 14 dans des applications de signalisation ferroviaire et de commutation.

16. Procédé d'installation d'un relais programmable à semi-conducteurs selon l'une quelconque des revendications 1 à 14 dans une application de signalisation ferroviaire et de commutation, comprenant les étapes de:
(i) choix d'au moins une des connexions appropriées sur la base de relais pour alimenter l'entrée de déclenchement ;
(ii) choix de la valeur du seuil de tension d'entrée de déclenchement ;
(iii) choix de la polarité du seuil de tension d'entrée de déclenchement ;
(iv) choix de la capacité de l'au moins un circuit de commutation de conserver son état existant lors de la disparition de l'entrée de déclenchement ; et
(v) fixer de façon amovible la base de relais de l'étape (i) à un tableau de connexion.

17. Procédé selon la revendication 16, dans lequel une pluralité de relais programmables à semi-conducteurs est installée à l'étape (v).

18. Procédé selon la revendication 16 ou la revendication 17, dans lequel le tableau de connexion est un tableau de connexion de relais de signalisation.
